# EUROPEAN PATENT APPLICATION

(11) **EP 4 074 201 A1**
(43) Date of publication of application: **19.10.2022**
(21) Application number: 21883018.0
(22) Date of filing: 14.09.2021
(51) Int. Cl.: A24F 40/50, A24F 40/465, A24F 40/51, A24F 40/60, H05B 6/10, G01R 23/07

(54) **INDUCTION HEATING-TYPE AEROSOL GENERATION DEVICE AND METHOD FOR CONTROLLING SAME**

(30) Priority: 22.10.2020 KR 20200137284
(71) Applicant: KT&G Corporation, Daedeok-gu Daejeon 34337 (KR)
(72) Inventor: SEO, Jang Won, Daejeon 34128 (KR); GO, Gyoung Min, Daejeon 34128 (KR); BAE, Hyung Jin, Daejeon 34128 (KR); JANG, Chul Ho, Daejeon 34128 (KR); JEONG, Min Seok, Daejeon 34128 (KR); JEONG, Jong Seong, Daejeon 34128 (KR); JUNG, Jin Chul, Daejeon 34128 (KR)
(74) Representative: Ter Meer Steinmeister & Partner
(86) International application number: PCT/KR2021/012466
(87) International publication number: WO 2022/085946

(57) **Abstract**

Provided herein are an induction heating-type aerosol generation device, which has a function of determining the suitability of an aerosol-generating article, and a control method thereof. The induction heating-type aerosol generation device according to some embodiments of the present disclosure includes a housing which has an accommodation space for accommodating an aerosol-generating article, an inductor which is disposed in a form surrounding at least a portion of the aerosol-generating article accommodated in the accommodation space to inductively heat the accommodated aerosol-generating article, and a controller which controls the inductor. The controller may apply a predetermined article determining frequency to the inductor, may measure an electrical signal that changes according to the applied article determining frequency, and may determine suitability of the accommodated aerosol-generating article only on the basis of a result of measurement, without an additional sensor.

## Description

### [Technical Field]

The present disclosure relates to an induction heating-type aerosol generation device and a control method thereof, and more particularly, to an induction heating-type aerosol generation device, which has a function of determining the suitability of an aerosol-generating article, and a control method performed in the device.

### [Background Art]

In recent years, demand for alternative methods that overcome the disadvantages of general cigarettes has increased. For example, demand for heating-type aerosol generation devices that electrically heat a cigarette to generate an aerosol has increased. Accordingly, active research has been carried out on heating-type aerosol generation devices.

Also, active research is being carried out on technology for determining the suitability or type of cigarette inserted into an aerosol generation device. This is because, since a heating method varies and a system of a cigarette also varies according to an aerosol generation device, in order to prevent a failure of the device and provide a suitable smoking experience to a user, there is a need to determine the suitability of an inserted cigarette before driving the aerosol generation device. For example, some aerosol generation devices detect, through an inductive sensor, a change in a magnetic field that is caused by an aluminum foil introduced into a medium of a target cigarette, thus determining the suitability of the inserted cigarette.

Meanwhile, recently, devices that heat a cigarette by induction heating to generate an aerosol have been proposed. For example, a device that inductively heats a susceptor, which is disposed in a form surrounding a cigarette accommodated therein from the outside, through an induction coil to generate an aerosol has been proposed. However, in the case of the aerosol generation device having the proposed structure, since the induction coil surrounds a medium portion of the cigarette, the determining method described above is difficult to apply. Accordingly, a need for a new method of determining the suitability of a cigarette has arisen.

### [Disclosure]

### [Technical Problem]

Some embodiments of the present disclosure are directed to providing an induction heating-type aerosol generation device, which has a function of determining the suitability of an aerosol-generating article, and a control method performed in the device.

Some embodiments of the present disclosure are also directed to providing an induction heating-type aerosol generation device, which has a function of determining the type of aerosol-generating article, and a control method performed in the device.

Objectives of the present disclosure are not limited to the above-mentioned objectives, and other unmentioned objectives should be clearly understood by those of ordinary skill in the art to which the present disclosure pertains from the description below.

### [Technical Solution]

An induction heating-type aerosol generation device according to some embodiments of the present disclosure includes a housing which has an accommodation space for accommodating an aerosol-generating article, an inductor which is disposed in a form surrounding at least a portion of the aerosol-generating article accommodated in the accommodation space to inductively heat the accommodated aerosol-generating article, and a controller which applies a predetermined article determining frequency to the inductor, measures an electrical signal that changes according to the applied article determining frequency, and performs a determining operation for the accommodated aerosol-generating article on the basis of a result of measurement.

In some embodiments, the controller may perform the determining operation only on the basis of the result of measurement, without another sensor for determining the accommodated aerosol-generating article.

In some embodiments, the article determining frequency may be a frequency spaced a predetermined distance apart from a resonant frequency of the inductor in a frequency domain.

In some embodiments, the controller may determine the suitability of the accommodated aerosol-generating article on the basis of the result of measurement and, in response to a determined result indicating that the accommodated aerosol-generating article is unsuitable, provide the determined result in a form recognizable by a user.

In some embodiments, the controller may, on the basis of a change amount of current, determine whether a susceptor element is present in the accommodated aerosol-generating article or determine the amount of the susceptor element.

In some embodiments, the controller may, on the basis of a change amount of current, determine a material of the susceptor element included in the accommodated aerosol-generating article.

In some embodiments, the controller may apply the article determining frequency to the inductor while varying the article determining frequency within a predetermined frequency range and may, on the basis of a change pattern of current according to the varying article determining frequency, determine a material of the susceptor element included in the accommodated aerosol-generating article.

In some embodiments, the controller may, on the basis of a change amount of current, determine the form of the susceptor element included in the accommodated aerosol-generating article.

In some embodiments, the induction heating-type aerosol generation device may further include a temperature measurer which measures a temperature of the accommodated aerosol-generating article, and the controller may apply the article determining frequency to the inductor while varying the article determining frequency within a predetermined frequency range, may, on the basis of a result of temperature measurement according to the varying article determining frequency, estimate a frequency suitable for the susceptor element included in the accommodated aerosol-generating article, and may, on the basis of the estimated frequency, determine a thickness of the susceptor element.

A control method of an induction heating-type aerosol generation device according to some embodiments of the present disclosure, which is a control method of a device that inductively heats an aerosol-generating article through an inductor to generate an aerosol, includes applying a predetermined article determining frequency to the inductor to operate the inductor, measuring an electrical signal that changes according to the applied article determining frequency, and performing a determining operation for the aerosol-generating article on the basis of a result of measurement.

A computer program according to some embodiments of the present disclosure may be combined with hardware and stored in a computer-readable recording medium in order to execute steps of applying a predetermined article determining frequency to an inductor to operate the inductor, measuring an electrical signal that changes according to the applied article determining frequency, and performing a determining operation for the aerosol-generating article on the basis of a result of measurement.

### [Advantageous Effects]

According to some embodiments of the present disclosure, by measuring an electrical signal that changes according to an article determining frequency applied to an inductor, it is possible to accurately determine the suitability or type of inserted aerosol-generating article without a sensor. For example, whether the inserted aerosol-generating article is an induction heating-type article including a susceptor element or is a dedicated article suitable for a device can be determined. Accordingly, it is possible to address problems such as causing a failure of the device or providing an unsuitable smoking experience due to inserting an unsuitable aerosol-generating article (e.g., a case where heating does not occur due to inserting an aerosol-generating article that is not an induction heating type, a case where heating occurs with an unsuitable temperature profile due to inserting an undedicated aerosol-generating article, etc.). Further, since a sensor for determining an aerosol-generating article is not required, manufacturing costs of an aerosol generation device can be reduced, and design complexity thereof can also be reduced.

Also, characteristics (e.g., amount, material, thickness, form, etc.) of a susceptor element can be determined on the basis of a measurement result (e.g., a change amount of current, a change pattern of current, a temperature, etc.) according to application of an article determining frequency. Accordingly, determination accuracy for an aerosol-generating article can be improved, the type of aerosol-generating article can be more accurately determined, and a smart control function according to a characteristic of the susceptor element (e.g., automatic setting of a suitable induction heating frequency according to a thickness of the susceptor element) can be implemented.

The advantageous effects according to the technical spirit of the present disclosure are not limited to the above-mentioned advantageous effects, and other unmentioned advantageous effects should be clearly understood by those of ordinary skill in the art from the description below.

### [Description of Drawings]

FIGS. 1 to 3 illustrate various types of induction heating-type aerosol generation devices according to some embodiments of the present disclosure.
FIGS. 4 and 5 are exemplary views for schematically describing a control method of an induction heating-type aerosol generation device according to some embodiments of the present disclosure.
FIG. 6 is an exemplary flowchart illustrating a control method of an induction heating-type aerosol generation device according to a first embodiment of the present disclosure.
FIGS. 7 and 8 are exemplary views for describing a control method of an induction heating-type aerosol generation device according to a second embodiment of the present disclosure.
FIG. 9 is an exemplary flowchart illustrating a control method of an induction heating-type aerosol generation device according to a third embodiment of the present disclosure.
FIGS. 10 to 13 are exemplary views illustrating various forms of susceptor elements and an aerosol-generating article including the same that may be referenced in the third embodiment of the present disclosure.
FIGS. 14 and 15 are exemplary views for describing a control method of an induction heating-type aerosol generation device according to a fourth embodiment of the present disclosure.

### [Modes of the Invention]

Hereinafter, preferred embodiments of the present disclosure will be described in detail with reference to the accompanying drawings. Advantages and features of the present disclosure and methods of achieving the same should become clear with embodiments described in detail below with reference to the accompanying drawings. However, the technical spirit of the present disclosure is not limited to the following embodiments and may be implemented in various different forms. The embodiments make the technical spirit of the present disclosure complete and are provided to completely inform those of ordinary skill in the art to which the present disclosure pertains of the scope of the present disclosure. The technical spirit of the present disclosure is defined only by the scope of the claims.

In assigning reference numerals to components of each drawing, it should be noted that the same reference numerals are assigned to the same components as much as possible even when the components are illustrated in different drawings. Also, in describing the present disclosure, when detailed description of a known related configuration or function is deemed as having the possibility of obscuring the gist of the present disclosure, the detailed description thereof will be omitted.

Unless otherwise defined, all terms including technical or scientific terms used herein have the same meaning as commonly understood by those of ordinary skill in the art to which the present disclosure pertains. Terms defined in commonly used dictionaries should not be construed in an idealized or overly formal sense unless expressly so defined herein. Terms used in the following embodiments are for describing the embodiments and are not intended to limit the present disclosure. In the following embodiments, a singular expression includes a plural expression unless the context clearly indicates otherwise.

Also, in describing components of the present disclosure, terms such as first, second, A, B, (a), and (b) may be used. Such terms are only used for distinguishing one component from another component, and the essence, order, sequence, or the like of the corresponding component is not limited by the terms. In a case in which a certain component is described as being "connected," "coupled," or "linked" to another component, it should be understood that, although the component may be directly connected or linked to the other component, still another component may also be "connected," "coupled," or "linked" between the two components.

The terms "comprises" and/or "comprising" used herein do not preclude the presence or addition of one or more components, steps, operations, and/or devices other than those mentioned.

Some terms used in various embodiments of the present disclosure will be clarified prior to description thereof.

In the following embodiments, "aerosol-forming substrate" may refer to a material that is able to form an aerosol. The aerosol may include a volatile compound. The aerosol-forming substrate may be a solid or liquid. For example, solid aerosol-forming substrates may include solid materials based on tobacco raw materials such as reconstituted tobacco leaves, shredded tobacco, and reconstituted tobacco, and liquid aerosol-forming substrates may include liquid compositions based on nicotine, tobacco extracts, humectants, and/or various flavoring agents. However, the scope of the present disclosure is not limited to the above-listed examples. In the following embodiments, "liquid" may refer to a liquid aerosol-forming substrate.

In the following embodiments, "aerosol-generating article" may refer to an article that is able to generate an aerosol. The aerosol-generating article may include an aerosol-forming substrate. A typical example of the aerosol-generating article may include a cigarette, but the scope of the present disclosure is not limited to such an example.

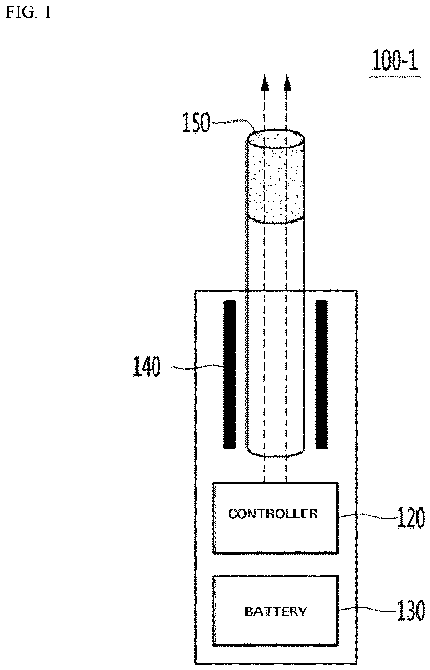

In the following embodiments, "aerosol generation device" may refer to a device that generates an aerosol using an aerosol-forming substrate in order to generate an aerosol that can be inhaled directly into the user's lungs through the user's mouth. Refer to FIGS. 1 to 3 for various examples of the aerosol generation device. However, since the types of aerosol generation devices may be more diverse, the scope of the present disclosure is not limited to such examples.

In the following embodiments, "puff refers to inhalation by a user, and the inhalation may refer to a situation in which a user draws smoke into his or her oral cavity, nasal cavity, or lungs through the mouth or nose.

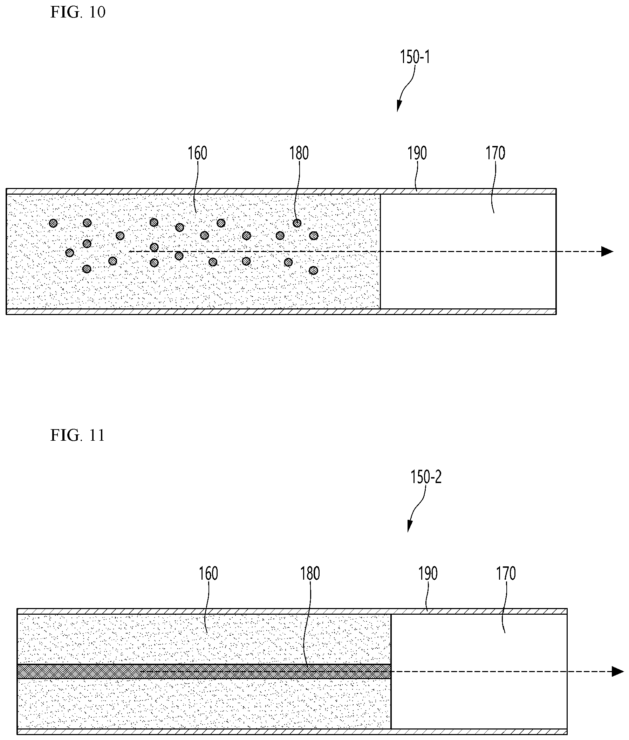

In the following embodiments, "upstream" or "upstream direction" may refer to a direction moving away from an oral region of a user, and "downstream" or "downstream direction" may refer to a direction approaching the oral region of the user. The terms "upstream" and "downstream" may be used to describe relative positions of elements constituting an aerosol-generating article. For example, in an aerosol-generating article (e.g., 150-1) illustrated in FIG. 10 and the like, a filter portion 170 is disposed downstream of or in a downstream direction from a medium portion 160, and the medium portion 160 is disposed upstream of or in an upstream direction from the filter portion 170.

Hereinafter, various embodiments of the present disclosure will be described in detail with reference to the accompanying drawings.

FIGS. 1 to 3 illustrate various types of induction heating-type aerosol generation devices 100-1 to 100-3 according to some embodiments of the present disclosure. Hereinafter, in describing an induction heating-type aerosol-generating article 150 or the induction heating-type aerosol generation devices 100-1 to 100-3, for convenience of description, the term "induction heating-type" will be omitted. Hereinafter, the aerosol generation devices 100-1 to 100-3 will be described.

First, as illustrated in FIG. 1, the aerosol generation device 100-1 may include a housing, a heater portion 140, a controller 120, and a battery 130. However, only the components relating to the embodiment of the present disclosure are illustrated in FIG. 1. Therefore, those of ordinary skill in the art to which the present disclosure pertains should understand that the aerosol generation device 100-1 may further include general-purpose components other than the components illustrated in FIG. 1. For example, the aerosol generation device 100-1 may further include an output module (e.g., a motor, a display) which outputs a state of the device and/or an input module (e.g., a button) for receiving a user input (e.g., to turn on or off the device). Hereinafter, each component of the aerosol generation device 100-1 will be described.

The housing may form an exterior of the aerosol generation device 100-1. Also, the housing may form an accommodation space for accommodating the aerosol-generating article 150. The aerosol-generating article 150 accommodated in the accommodation space may generate an aerosol due to being heated by the heater portion 140, and the generated aerosol may be inhaled by a user through the oral region of the user.

Next, the heater portion 140 may inductively heat the aerosol-generating article 150 accommodated in the accommodation space to generate an aerosol. Although not clearly illustrated, a susceptor element may be embedded in the aerosol-generating article 150, and the heater portion 140 may include an inductor and an oscillator which generates a frequency applied to the inductor. Also, the heater portion 140 may inductively heat the susceptor element embedded in the aerosol-generating article 150 through the inductor to generate an aerosol. In this case, since the susceptor element is not required to be included in the heater portion 140, the structure of the heater portion 140 may be simplified. Also, as a result, design complexity of the aerosol generation device 100-1 may be reduced, the weight and size of the aerosol generation device 100-1 may be reduced, and a defect occurrence rate may also be reduced during manufacture.

Examples of the inductor may include an induction coil, but the scope of the present disclosure is not limited thereto. Also, the inductor may be disposed in a form surrounding at least a portion of the aerosol-generating article 150 accommodated in the accommodation space, but the scope of the present disclosure is not limited thereto.

Next, the controller 120 may control the overall operation of the aerosol generation device 100-1. For example, the controller 120 may control the operation of the heater portion 140 and the battery 130 and also control the operation of other components included in the aerosol generation device 100-1. The controller 120 may control the power supplied by the battery 130, a heating temperature of the heater portion 140, and the like. Also, the controller 120 may check a state of each of the components of the aerosol generation device 100-1 and determine whether the aerosol generation device 100-1 is in an operable state.

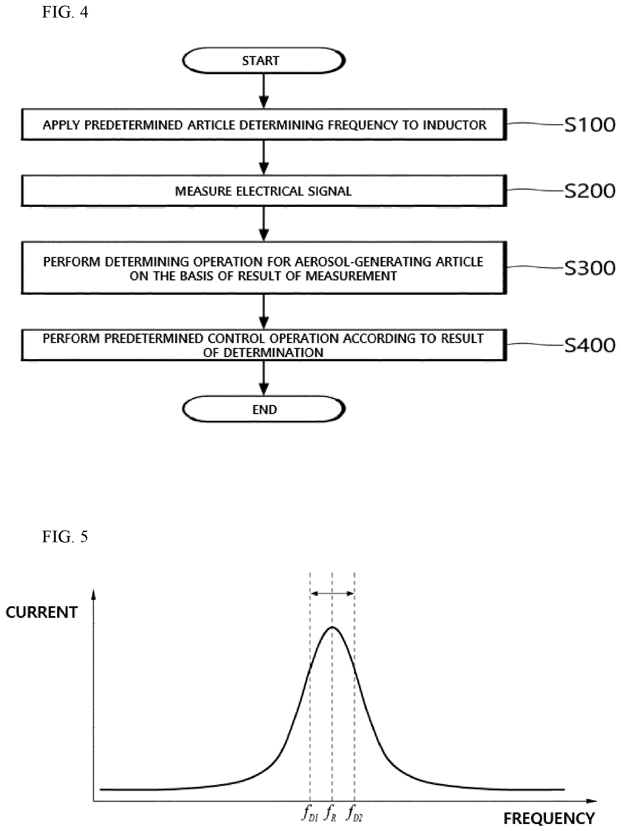

In some embodiments, the controller 120 may apply a predetermined article determining frequency to the inductor of the heater portion 140, measure an electrical signal that changes according to the applied article determining frequency, and perform a determining operation for the accommodated aerosol-generating article 150 on the basis of a result of measurement. Here, the article determining frequency may be the same as or different from an induction heating frequency applied to the inductor at the time of induction heating. Also, the determining operation may include all kinds of determining operations such as determining the suitability or type of aerosol-generating article 150 or determining characteristics of a susceptor element. The present embodiment will be described in detail below with reference to FIG. 4 and so on.

The controller 120 may be implemented with at least one processor. The processor may also be implemented with an array of a plurality of logic gates or implemented with a combination of a general-purpose microprocessor and a memory which stores a program that may be executed by the microprocessor. Also, those of ordinary skill in the art to which the present disclosure pertains should clearly understand that the controller 120 may also be implemented with other forms of hardware.

Next, the battery 130 may supply the power used to operate the aerosol generation device 100-1. For example, the battery 130 may supply power to the heater portion 140 and may also supply power required to operate the controller 120.

Also, the battery 130 may supply power required to operate electrical components such as a display (not illustrated), a sensor (not illustrated), and a motor (not illustrated) which are installed in the aerosol generation device 100-1.

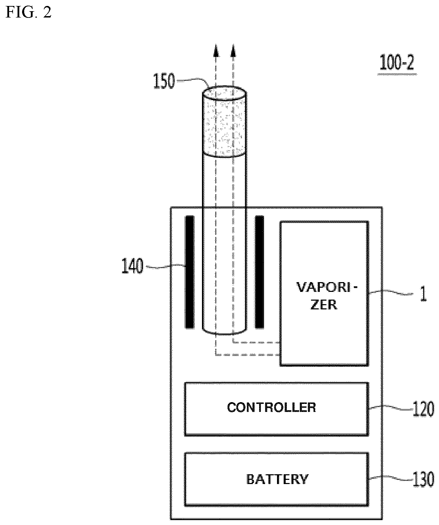

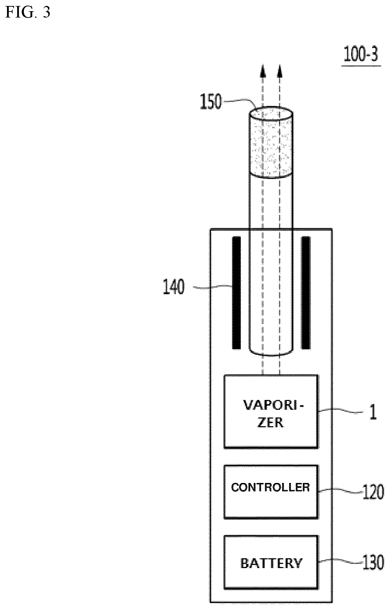

Hereinafter, other types of aerosol generation devices 100-2 and 100-3 will be described with reference to FIGS. 2 and 3.

FIGS. 2 and 3 are exemplary views schematically illustrating hybrid-type aerosol generation devices 100-2 and 100-3 in which the aerosol-generating article 150 and a liquid aerosol-forming substrate are used together. Specifically, FIG. 2 illustrates the device 100-2 in which a vaporizer 1 and the aerosol-generating article 150 are arranged in parallel, and FIG. 3 illustrates the device 100-3 in which the vaporizer 1 and the aerosol-generating article 150 are arranged in series. However, the scope of the present disclosure is not limited to such examples, and the arrangement form inside aerosol generation devices (e.g., 100-1 to 100-3) may be modified in various ways.

As illustrated in FIG. 2 or 3, the aerosol generation devices 100-2 and 100-3 may further include the vaporizer 1. However, this is only a preferred embodiment for achieving the objectives of the present disclosure, and, of course, some components may be added or omitted as necessary. Hereinafter, each component of the aerosol generation devices 100-2 and 100-3 will be described. However, for clarity of the present disclosure, description of contents overlapping with those relating to the aerosol generation device 100-1 described above will be omitted.

The vaporizer 1 may vaporize a liquid aerosol-forming substrate to generate an aerosol. For example, the vaporizer 1 may be configured to include a liquid reservoir which stores the liquid aerosol-forming substrate, a wick which absorbs the stored liquid, and a liquid vaporizing element which vaporizes the absorbed liquid. Here, the liquid vaporizing element may be implemented as a heating element, implemented as a vibrating element which vaporizes a liquid through ultrasonic vibrations, or implemented in other forms. Also, the scope of the present disclosure is not limited to such examples. In addition, the vaporizer 1 may be implemented to have a different structure. For example, the vaporizer 1 may be implemented to have a structure that does not include a wick.

The aerosol generated in the vaporizer 1 may pass through the aerosol-generating article 150 and be inhaled by the user through the oral region of the user. The liquid vaporizing element of the vaporizer 1 may be controlled by the controller 120.

Refer to the above descriptions relating to FIG. 1 for the descriptions of the heater portion 140, the battery 130, and the controller 120.

Various types of aerosol generation devices 100-1 to 100-3 according to some embodiments of the present disclosure have been described above with reference to FIGS. 1 to 3. Hereinafter, a control method of an aerosol generation device will be described in detail with reference to FIG. 4 and so on.

Each step of the control method described below may be performed by an aerosol generation device including a controller (or a processor). Also, each step of the control method may be implemented as one or more instructions executed by the controller (or processor) of the aerosol generation device. Hereinafter, description will be continued assuming that each step of the control method is performed by the controller 120 of the aerosol generation devices 100-1 to 100-3 illustrated in FIGS. 1 to 3. Therefore, in the following description, when the subject of a specific operation is omitted, the specific operation may be understood as being performed by the controller 120.

FIG. 4 is an exemplary flowchart schematically illustrating a control method of the aerosol generation device (e.g., 100-1) according to some embodiments of the present disclosure. However, this is only a preferred embodiment for achieving the objectives of the present disclosure, and, of course, some steps may be added or omitted as necessary.

As illustrated, the control method may begin by the controller 120 applying a predetermined article determining frequency to the inductor (S100). Here, the article determining frequency may refer to a frequency applied to the inductor in order to perform a determining operation for the aerosol-generating article 150. As mentioned above, the article determining frequency may be a frequency which is the same as or different from the induction heating frequency applied to the inductor at the time of inductively heating the aerosol-generating article 150.

In some embodiments, as illustrated in FIG. 5, the article determining frequency may be set as a frequency (e.g., f_{D1}, f_{D2}) spaced a predetermined distance apart from a resonant frequency of the inductor (that is, a frequency f_{R} at which the inductor is able to operate with maximum power) in a frequency domain. In this case, an overcurrent may be prevented from flowing in a circuit element such as the inductor, thus being advantageous in terms of circuit protection, and battery power consumed due to the determining operation for the aerosol-generating article 150 may be minimized.

In step S200, the controller 120 may measure an electrical signal that changes as the article determining frequency is applied. For example, the controller 120 may include a measurer (e.g., a current measuring circuit, a voltage measuring circuit, etc.) capable of measuring an electrical signal and may measure the electrical signal through the included measurer. In this step, the controller 120 may measure an electrical signal output from the battery 130 or an electrical signal from the heater portion 140 (e.g., an electrical signal from the vicinity of the inductor), but the scope of the present disclosure is not limited thereto, and a specific measurement site and/or the type of measurer may be designed in various ways. Also, an electrical signal to be measured may be, for example, current, voltage, power, inductance, or the like but is not limited thereto.

In step S300, the controller 120 may, on the basis of a result of measurement, perform the determining operation for the aerosol-generating article 150 accommodated in the accommodation space. Here, the result of measurement may include any of various forms of raw data that are measurable and processing information thereof. For example, when a target to be measured is current, the result of measurement may include a peak value, a slope of increase/decrease, a waveform, and a change amount of current or statistics thereof. Also, the determining operation may include all kinds of determining operations such as determining the suitability or type of aerosol-generating article 150 or determining characteristics (e.g., material, amount, form, etc.) of a susceptor element. In addition, since targets to be determined may be more diverse, the scope of the present disclosure is not limited by the examples listed above. For example, determining the suitability of the aerosol-generating article 150 may include determining whether the aerosol-generating article 150 accommodated in the accommodation space is an induction heating-type article, determining whether the aerosol-generating article 150 accommodated in the accommodation space is a dedicated article, and the like. However, the determining of the suitability of the aerosol-generating article 150 is not limited thereto.

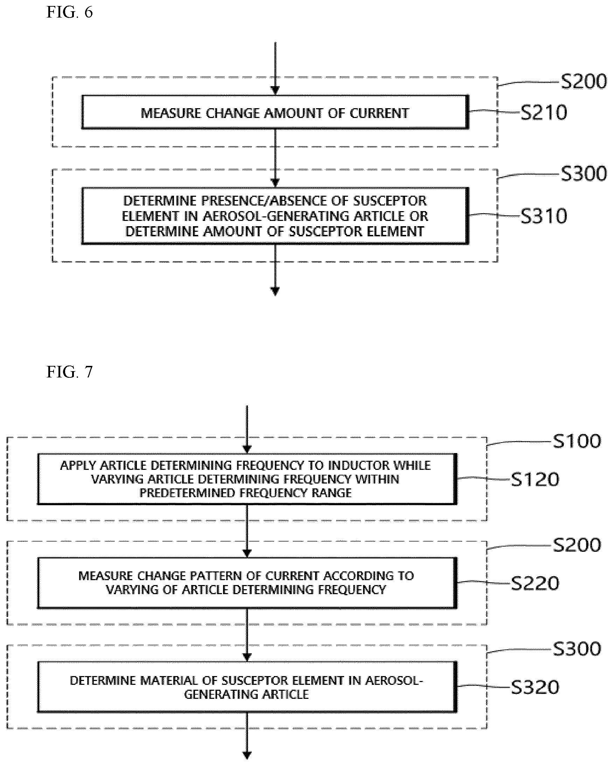

Specific examples of the determining operation performed in this step will be described in detail below with reference to FIG. 6 and so on.

In step S400, the controller 120 may, according to a result of determination, perform a predetermined con trol operation. In this step, the control operation may be set in various ways.

For example, when the accommodated aerosol-generating article 150 is determined as unsuitable, the controller 120 may provide the determined result in a form recognizable by the user. For example, the controller 120 may visually provide the determined result through a display which is included in the controller 120 or linked with the controller 120, may aurally provide the determined result through sound, or may tactually provide the determined result through vibrations or the like.

As another example, when the accommodated aerosol-generating article 150 is determined as unsuitable, the controller 120 may stop the operation of the aerosol generation device (e.g., 100-1).

As still another example, when the accommodated aerosol-generating article 150 is determined as suitable, the controller 120 may provide the determined result in a form recognizable by the user and may drive the aerosol generation device (e.g., 100-1) (e.g., start induction heating) for smoking.

As yet another example, when the type of accommodated aerosol-generating article 150 is determined, the controller 120 may provide the determined result in a form recognizable by the user and may load a temperature profile that matches the determined type or drive the aerosol generation device (e.g., 100-1) (e.g., start induction heating) according to the temperature profile matching the determined type.

The control method of FIG. 4 that has been described above may be performed before the user requests the use of the aerosol generation device (e.g., 100-1) (e.g., before the user starts smoking). For example, in response to a user input (e.g., an input on a button, etc.) requesting the start of smoking, the controller 120 may perform the control method to perform the determining operation for the aerosol-generating article 150. Alternatively, the control method may also be performed periodically or non-periodically during the use of the aerosol generation device (e.g., 100-1). In this case, a user's mistake of, after inserting a dedicated aerosol-generating article into the aerosol generation device (e.g., 100-1), inserting and smoking a different aerosol-generating article at the time of smoking can be effectively prevented.

The control method of the aerosol generation device (e.g., 100-1) according to some embodiments of the present disclosure has been schematically described above with reference to FIGS. 4 and 5. According to the method described above, by measuring an electrical signal that changes according to the article determining frequency applied to the inductor, it is possible to determine the suitability and/or type of inserted aerosol-generating article 150 without an additional sensor. Accordingly, it is possible to address problems such as causing a failure of the device or providing an unsuitable smoking experience to the user due to inserting an unsuitable aerosol-generating article (e.g., a case where heating does not occur due to inserting an aerosol-generating article that is not an induction heating type, a case where heating occurs with an unsuitable temperature profile due to inserting an undedicated aerosol-generating article, etc.). Further, since a sensor for determining an aerosol-generating article is not required, manufacturing costs of the aerosol generation device may be reduced, and design complexity thereof may also be reduced.

Hereinafter, specific examples of the above-described control method will be described with reference to FIG. 6 and so on. In the following description, for clarity of the present disclosure, description of contents overlapping with those described above will be omitted. Also, hereinafter, for convenience of understanding, description will be continued assuming that an electrical signal to be measured is "current." However, the scope of the present disclosure is not limited thereto, and the control method described below may also be applied when a target to be measured is another type of electrical signal (e.g., voltage, power, inductance).

FIG. 6 is an exemplary flowchart for describing a control method of the aerosol generation device (e.g., 100-1) according to a first embodiment of the present disclosure.

As illustrated in FIG. 6, the controller 120 may measure the amount of current that changes as the article determining frequency is applied (S210) and may, on the basis of the measured change amount of current, determine whether a susceptor element is present in the aerosol-generating article 150 or determine the amount of susceptor element (that is, content of susceptor element) (S310).

For example, in response to determining that the amount of current (e.g., the amount of current of the heater portion 140, the amount of current output from the battery 130) measured after applying the article determining frequency has increased by a reference value or more as compared to before applying the article determining frequency, the controller 120 may determine that the susceptor element is present in the aerosol-generating article 150. This is because, when the susceptor element is present in the aerosol-generating article 150, an induced current (that is, an eddy current) may be generated in the susceptor element, and as a result, the amount of current of the heater portion 140 or the amount of current output from the battery 130 will increase. In the opposite case, the controller 120 may determine that the susceptor element is not present in the aerosol-generating article 150.

As another example, on the basis of the extent to which the amount of current has increased after applying the article determining frequency, the controller 120 may determine the amount of susceptor element (material). For example, the controller 120 may determine that the larger the increase in the amount of current, the larger the amount of susceptor element included in the aerosol-generating article 150. This is because, since the amount of induced current generated would be larger as the amount of susceptor element (material) is larger, the amount of current of the heater portion 140 or the amount of current output from the battery 130 is highly likely to be proportional to the amount of susceptor element (material).

Meanwhile, the controller 120 may also determine the suitability and/or type of aerosol-generating article 150 on the basis of the determined presence/absence of the susceptor element and/or information thereof. For example, in response to determining that the susceptor element is present, the controller 120 may determine that the aerosol-generating article 150 is a suitable article (e.g., an induction heating-type article). In the opposite case, the controller 120 may determine that the aerosol-generating article 150 is an unsuitable article. As another example, in response to determining that the amount of susceptor element (material) is a reference value or more or is within a reference range, the controller 120 may determine that the aerosol-generating article 150 is a suitable article (e.g., a dedicated article). In the opposite case, the controller 120 may determine that the aerosol-generating article 150 is an unsuitable article. As still another example, the controller 120 may determine that the aerosol-generating article 150 is a first type of induction heating-type article when the amount of susceptor element (material) is a reference value or more and may determine that the aerosol-generating article 150 is a second type of induction heating-type article in the opposite case. The suitability and/or type determining operation of the controller 120 may be performed in the same or similar way for characteristics (e.g., material, form, thickness, etc.) of the susceptor element that are mentioned below.

Meanwhile, in some embodiments, the controller 120 may also determine a material of the susceptor element in the aerosol-generating article 150 on the basis of the measured change amount of current. This is because, even when the same article determining frequency is applied, the amount of induced current generated in the susceptor element varies according to the material, and accordingly, the change amount of current of the heater portion 140 or the battery 130 also varies. For example, the controller 120 may determine the material of the susceptor element by comparing the measured change amount of current with pre-stored information on the change amount of current for each material.

The control method of the aerosol generation device (e.g., 100-1) according to the first embodiment of the present disclosure has been described above with reference to FIG. 6. According to the method described above, on the basis of the change amount of current that is measured as the article determining frequency is applied, the presence/absence of the susceptor element in the aerosol-generating article 150 and/or the amount of susceptor element therein may be accurately determined without a separate sensor. The suitability and/or type of aerosol-generating article 150 may also be accurately determined.

Hereinafter, a control method of the aerosol generation device (e.g., 100-1) according to a second embodiment of the present disclosure will be described with reference to FIG. 7.

FIG. 7 is an exemplary flowchart illustrating the control method of the aerosol generation device (e.g., 100-1) according to the second embodiment of the present disclosure.

As illustrated in FIG. 7, the control method according to the present embodiment may begin by the controller 120 applying an article determining frequency to the inductor while varying the article determining frequency within a predetermined frequency range (S120). For example, the controller 120 may apply the article determining frequency to the inductor while increasing or decreasing the article determining frequency within a predetermined frequency range or randomly changing the article determining frequency.

In step S220, the controller 120 may measure a change pattern of current according to varying of the article determining frequency. Here, the change pattern of current may be defined on the basis of various factors such as an average value, a peak value, a frequency of the peak value, an extent of increase/decrease, a slope of increase/decrease, and a waveform. For reference, feature values such as the peak value and the slope of increase/decrease may be related to magnetic permeability of the material. The higher the magnetic permeability of the material, the larger the peak value and the steeper the slope of increase/decrease (θ₁, θ₂).

In step S320, the controller 120 may, on the basis of the measured change pattern of current, determine the material of the susceptor element in the aerosol-generating article 150. For example, the controller 120 may determine the material of the susceptor element by comparing the measured change pattern of current with pre-stored information on the change pattern of current for each material.

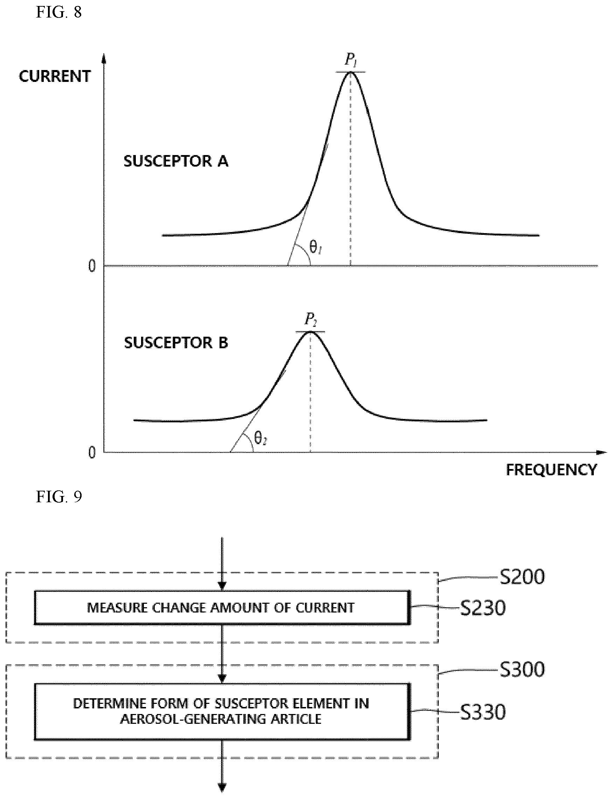

As a specific example, FIG. 8 illustrates changes in current according to frequency of susceptor elements A and B made of different materials. It can be seen that peak values (P₁, P₂) of current, frequencies (f₁, f₂) of the peak values (P₁, P₂), and slopes of increase/decrease (θ₁, θ₂) are different between the two susceptor elements A and B. Therefore, the controller 120 may measure the peak values (P₁, P₂), slopes of increase/decrease (θ₁, θ₂), and the like to determine the materials of the susceptor elements A and B.

Meanwhile, on the basis of the determined material information, the controller 120 may determine the suitability and/or type of aerosol-generating article 150. For example, on the basis of the material information of the susceptor element, the controller 120 may determine whether the aerosol-generating article 150 is a dedicated article or determine the type of aerosol-generating article 150.

The control method of the aerosol generation device (e.g., 100-1) according to the second embodiment of the present disclosure has been described above with reference to FIGS. 7 and 8. According to the method described above, on the basis of the change pattern of current according to the article determining frequency that varies, the material of the susceptor element in the aerosol-generating article 150 may be accurately determined without a separate sensor. The suitability and/or type of aerosol-generating article 150 may also be accurately determined.

Hereinafter, a control method of the aerosol generation device (e.g., 100-1) according to a third embodiment of the present disclosure will be described with reference to FIG. 9.

FIG. 9 is an exemplary flowchart illustrating the control method of the aerosol generation device (e.g., 100-1) according to the third embodiment of the present disclosure.

As illustrated in FIG. 9, the controller 120 may measure the amount of current that changes as the article determining frequency is applied (S230) and may, on the basis of the measured change amount of current, determine the form of the susceptor element in the aerosol-generating article 150 (S330). Hereinafter, the control method according to the present embodiment will be further described with reference to aerosol-generating articles 150-1 to 150-3 illustrated in FIGS. 10 to 13.

FIGS. 10 to 13 illustrate the aerosol-generating articles 150-1 to 150-3 associated with various forms of a susceptor element 180.

As illustrated, when the aerosol-generating articles 150-1 to 150-3 each include a medium portion 160, a filter portion 170 disposed downstream thereof, and a wrapper 190 which surrounds the medium portion 160 and the filter portion 170, the susceptor element 180 may be embedded in the medium portion 160 or may be disposed in a form surrounding the medium portion 160.

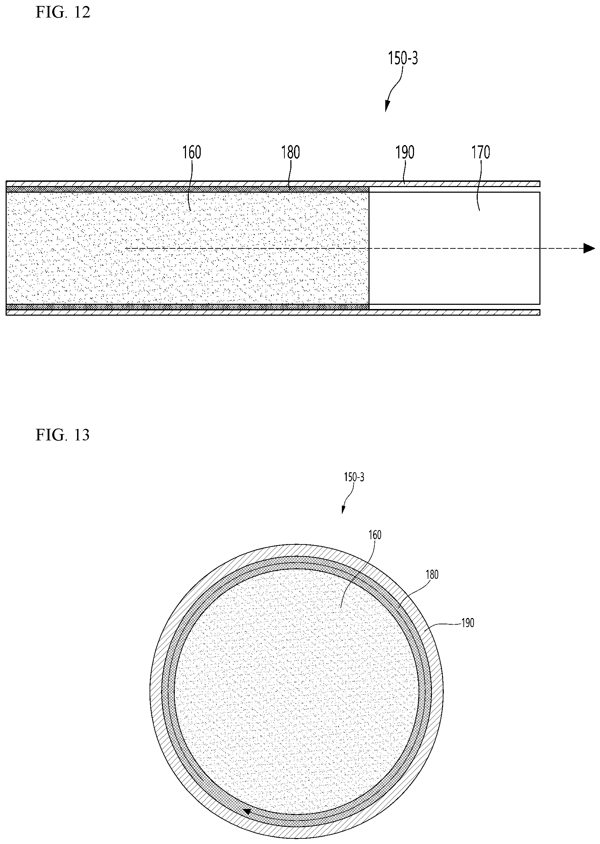

The susceptor element 180 may be processed into various forms and disposed in or around the medium portion 160. As illustrated, the susceptor element 180 may be embedded in the form of particles in the medium portion 160 (see FIG. 10), may be embedded in the form of an elongated body (e.g., a needle-shaped body, a rod-shaped body, a blade-shaped body, etc.) in the medium portion 160 so as to operate by internal heating (see FIG. 11), or may be processed into the form of wrapper and disposed around the medium portion 160 so as to operate by external heating (see FIG. 12). In addition, since the form of the susceptor element 180 may be more diverse, the scope of the present disclosure is not limited by the examples listed above.

When the susceptor element 180 is disposed in the form of a wrapper, as illustrated in FIG. 13, the susceptor element 180 may be disposed to form a closed loop. For example, both ends of the susceptor element 180 may be disposed to be connected to each other (or come in contact with each other), or the susceptor element 180 may be formed in a closed loop shape (e.g., a cylindrical shape). In this case, since an induced current generated in the susceptor element 180 due to induction heating may smoothly flow along the closed loop (see the arrow in FIG. 13), the heating efficiency of the susceptor element 180 may be significantly improved. For example, since a heating value of the susceptor element 180 relative to power applied to the inductor is increased, the medium portion 160 may be effectively heated.

In the above case, the controller 120 may determine the form of the susceptor element 180 on the basis of the measured change amount of current. The amount of susceptor material and a heating area vary according to the form of the susceptor element 180. This is because, as the amount of susceptor material increases and the heating area becomes larger, the amount of induced current of the susceptor element 180 increases, and thus, the amount of change of current at the heater portion 140 or battery 130 side also increases.

For example, the controller 120 may determine that the susceptor element 180 is in the form of particles (see FIG. 10) when the change amount of current (e.g., an increase amount of current) is less than a first reference value, may determine that the susceptor element 180 is in the form of an elongated body (see FIG. 11) when the change amount of current is the first reference value or more and less than a second reference value (which is a value greater than the first reference value), and may determine that the susceptor element 180 is in the form of a wrapper (see FIG. 12) when the change amount of current is the second reference value or more.

Meanwhile, in some embodiments, the aerosol generation device (e.g., 100-1) may further include a temperature measurer (e.g., a temperature sensor) which measures a temperature (e.g., a surface temperature) of the aerosol-generating article 150, and the controller 120 may further use a measurement result of the temperature measurer to determine the form of the susceptor element 180. For example, when the surface temperature (or temperature increase rate) of the aerosol-generating article (e.g., 150-3) at the time of applying the article determining frequency is a reference value or more, and the change amount of current is also a reference value or more, the controller 120 may determine that the susceptor element 180 is in the form of a wrapper. This is because, since the susceptor element 180 in the form of a wrapper heats the medium portion 160 from the outside, the surface temperature of the aerosol-generating article (e.g., 150-3) would be higher as compared to other forms or would rapidly increase. According to the present embodiment, the temperature measurer may be further utilized to more accurately determine the form of the susceptor element.

Meanwhile, the controller 120 may also determine the suitability and/or type of aerosol-generating article 150 on the basis of the determined form information of the susceptor element. For example, on the basis of the susceptor element form information, the controller 120 may determine whether the aerosol-generating article 150 is a dedicated article or may determine the type of aerosol-generating article 150.

The control method of the aerosol generation device (e.g., 100-1) according to the third embodiment of the present disclosure has been described above with reference to FIGS. 9 to 13. According to the method described above, on the basis of the amount of current that changes according to the article determining frequency, the form of the susceptor element in the aerosol-generating article 150 may be accurately determined without a separate sensor. The suitability and/or type of aerosol-generating article 150 may also be accurately determined.

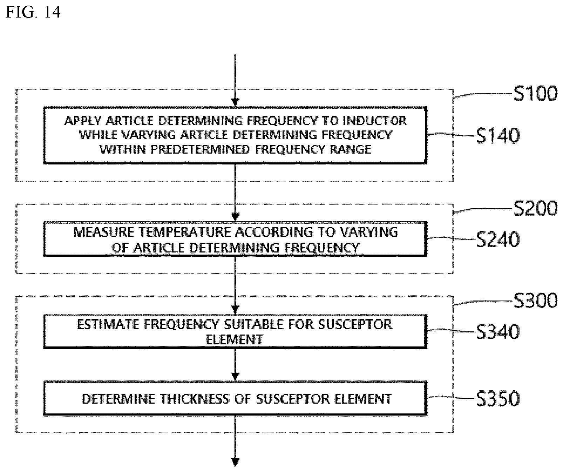

Hereinafter, a control method of the aerosol generation device (e.g., 100-1) according to a fourth embodiment of the present disclosure will be described with reference to FIG. 14.

FIG. 14 is an exemplary flowchart illustrating the control method of the aerosol generation device (e.g., 100-1) according to the fourth embodiment of the present disclosure.

As illustrated in FIG. 14, the control method according to the present embodiment may begin by the controller 120 applying an article determining frequency to the inductor while varying the article determining frequency within a predetermined frequency range (S140).

In step S240, the controller 120 may measure the temperature of the aerosol-generating article 150 (or the heating temperature of the susceptor element) according to varying of the article determining frequency. For example, the controller 120 may include a temperature measurer (e.g., a temperature sensor) which is able to measure the temperature (e.g., surface temperature) of the aerosol-generating article 150 and may measure the temperature of the aerosol-generating article 150 through the included temperature measurer.

In step S340, on the basis of the measured temperature, the controller 120 may estimate a frequency suitable for the susceptor element. For example, the controller 120 may estimate a frequency at which a temperature of a reference value or more (e.g., the maximum temperature) is measured among the applied article determining frequencies as a frequency suitable for the corresponding susceptor element.

In some embodiments, the controller 120 may also estimate a frequency suitable for the susceptor element on the basis of the change amount of current. For example, the controller 120 may estimate a frequency at which a change amount of current (e.g., a peak value) is measured as a reference value or more among the applied article determining frequencies as a frequency suitable for the corresponding susceptor element. In this case, since there is no need to include a temperature measurer, manufacturing costs of the aerosol generation device (e.g., 100-1) may be reduced.

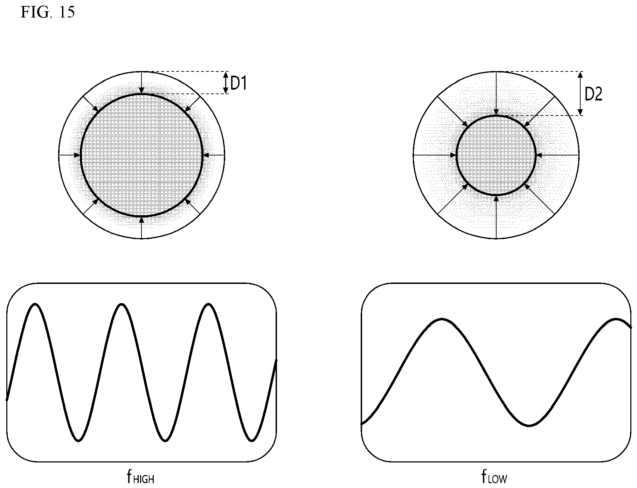

In step S350, the controller 120 may determine a thickness of the susceptor element on the basis of the estimated frequency. Specifically, the controller 120 may use the relationship between the current penetration depth and the frequency (e.g., frequency of induced current) to determine the thickness of the susceptor element. For better understanding, the relationship between the frequency and the current penetration depth will be described further with reference to FIG. 15.

As illustrated in FIG. 15, the higher the frequency of the induced current generated in the susceptor element, the shallower the current penetration depth (see f_{HIGH} and D1), and the lower the frequency, the deeper the current penetration depth (see f_{LOW} and D2). Therefore, a relatively high frequency may be suitable for a susceptor element having a small thickness, and a relatively low frequency may be suitable for a susceptor element having a large thickness. This is because, when an induced current having a high frequency is generated when the susceptor element has a large thickness, heat may only be generated on a surface and thus a heating value may be relatively low. For reference, since a frequency of the induced current generated in the susceptor element is determined by a frequency applied to the inductor, the controller 120 may control the frequency of the induced current through the applied frequency.

Therefore, the controller 120 may determine the thickness of the susceptor element to be relatively large as the estimated frequency is lower and, in the opposite case, may determine the thickness of the susceptor element to be relatively small. Also, the controller 120 may set the estimated frequency as an induction heating frequency of the inductor. In this way, since heat is generated throughout the susceptor element, heating efficiency relating to the aerosol-generating article 150 may be increased.

Meanwhile, the controller 120 may also determine the suitability and/or type of aerosol-generating article 150 on the basis of the determined thickness information of the susceptor element. For example, on the basis of the susceptor element thickness information, the controller 120 may determine whether the aerosol-generating article 150 is a dedicated article or may determine the type of aerosol-generating article 150.

The control method of the aerosol generation device (e.g., 100-1) according to the fourth embodiment of the present disclosure has been described above with reference to FIGS. 14 and 15. According to the method described above, a frequency suitable for the susceptor element may be estimated on the basis of the temperature measurement result according to varying of the article determining frequency, and on the basis of the estimated suitable frequency, the thickness of the susceptor element in the aerosol-generating article 150 may be accurately determined without a separate sensor. The suitability and/or type of aerosol-generating article 150 may also be accurately determined.

Each of the control methods according to the first to fourth embodiments of the present disclosure has been separately described above, but the first to fourth embodiments may be combined in various forms. For example, the first to fourth embodiments may be combined to determine the suitability and/or type of aerosol-generating article 150. As a more specific example, the controller 120 may determine the material, form, etc. of the susceptor element according to the above-described embodiments and may sum up the determined results to more accurately determine the suitability and/or type of aerosol-generating article 150. Also, the controller 120 may perform a suitable control operation according to the determined results. Alternatively, the controller 120 may calculate a suitability score (e.g., a score indicating an extent to which characteristics of the susceptor element are similar to those of a susceptor of a dedicated aerosol-generating article) according to each embodiment and may sum up the calculated suitability scores (e.g., obtain the sum of weighted values) to more accurately determine the suitability of the aerosol-generating article 150.

The technical spirit of the present disclosure described above with reference to FIGS. 1 to 15 may be implemented with computer-readable code on computer-readable recording media. Examples of the computer-readable recording media may include removable recording media (a compact disc (CD), a digital versatile disc (DVD), a Blu-Ray disk, a universal serial bus (USB) storage device, a removable hard disk) or non-removable recording media (a read-only memory (ROM), a random access memory (RAM), a built-in hard disk). Computer programs recorded in the computer-readable recording media may be sent to other computing devices through a network, such as the Internet, and installed in the other computing devices so as to be used in the other computing devices.

All the components constituting the embodiments of the present disclosure have been described above as being combined into one body or being operated in combination, but the technical spirit of the present disclosure is not necessarily limited to the embodiments. That is, any one or more of the components may be selectively operated in combination within the intended scope of the present disclosure.

The embodiments of the present disclosure have been described above with reference to the accompanying drawings, but those of ordinary skill in the art to which the present disclosure pertains should understand that the present disclosure may be embodied in other specific forms without changing the technical spirit or essential features thereof. Therefore, the embodiments described above should be understood as being illustrative, instead of limiting, in all aspects. The scope of the present disclosure should be interpreted by the claims below, and any technical spirit within the scope equivalent to the claims should be interpreted as falling within the scope of the technical spirit defined by the present disclosure.

## Claims

1. An induction heating-type aerosol generation device comprising:
a housing which has an accommodation space for accommodating an aerosol-generating article;
an inductor which is disposed in a form surrounding at least a portion of the aerosol-generating article accommodated in the accommodation space to inductively heat the accommodated aerosol-generating article; and
a controller which applies a predetermined article determining frequency to the inductor, measures an electrical signal that changes according to the applied article determining frequency, and performs a determining operation for the accommodated aerosol-generating article on the basis of a result of measurement.

2. The induction heating-type aerosol generation device of claim 1, wherein the controller performs the determining operation only on the basis of the result of measurement, without another sensor for determining the accommodated aerosol-generating article.

3. The induction heating-type aerosol generation device of claim 1, wherein the article determining frequency is a frequency spaced a predetermined distance apart from a resonant frequency of the inductor in a frequency domain.

4. The induction heating-type aerosol generation device of claim 1, wherein the controller determines suitability of the accommodated aerosol-generating article on the basis of the result of measurement and, in response to a determined result indicating that the accommodated aerosol-generating article is unsuitable, provides the determined result in a form recognizable by a user.

5. The induction heating-type aerosol generation device of claim 1, wherein, on the basis of a change amount of current, the controller determines whether a susceptor element is present in the accommodated aerosol-generating article or determines an amount of the susceptor element.

6. The induction heating-type aerosol generation device of claim 1, wherein, on the basis of a change amount of current, the controller determines a material of a susceptor element included in the accommodated aerosol-generating article.

7. The induction heating-type aerosol generation device of claim 1, wherein the controller applies the article determining frequency to the inductor while varying the article determining frequency within a predetermined frequency range and, on the basis of a change pattern of current according to the varying article determining frequency, determines a material of a susceptor element included in the accommodated aerosol-generating article.

8. The induction heating-type aerosol generation device of claim 1, wherein, on the basis of a change amount of current, the controller determines a form of a susceptor element included in the accommodated aerosol-generating article.

9. The induction heating-type aerosol generation device of claim 8, further comprising a temperature measurer which measures a temperature of the accommodated aerosol-generating article,
wherein the controller determines the form of the susceptor element also on the basis of a measurement result of the temperature measurer.

10. The induction heating-type aerosol generation device of claim 1, further comprising a temperature measurer which measures a temperature of the accommodated aerosol-generating article,
wherein the controller applies the article determining frequency to the inductor while varying the article determining frequency within a predetermined frequency range, on the basis of a result of temperature measurement according to the varying article determining frequency, estimates a frequency suitable for a susceptor element included in the accommodated aerosol-generating article, and on the basis of the estimated frequency, determines a thickness of the susceptor element.

11. The induction heating-type aerosol generation device of claim 10, wherein the controller sets the estimated frequency as an induction heating frequency of the inductor.

12. A control method of an induction heating-type aerosol generation device, which is a control method of a device that inductively heats an aerosol-generating article through an inductor to generate an aerosol, the control method comprising:
applying a predetermined article determining frequency to the inductor to operate the inductor;
measuring an electrical signal that changes according to the applied article determining frequency; and
performing a determining operation for the aerosol-generating article on the basis of a result of measurement.
